# FASCICULE DE BREVET EUROPEEN

(11) **EP 0 343 072 B1**
(45) Date de publication et mention de la délivrance du brevet: **31.03.1993**
(21) Numéro de dépôt: 89401369.7
(22) Date de dépôt: 18.05.1989
(51) Int. Cl.: F27B 17/00, F27B 5/04, F27D 5/00, F27D 23/00, H01L 21/00, C30B 25/10, H05B 3/60

(54) **Dispositif de transmission de chaleur sous vide par des grains**
Vakuumwärmeübertragungseinrichtung durch Körner
Device for heat transmission under vacuum with grains

(30) Priorité: 20.05.1988 FR 8806781
(43) Date de publication de la demande: 23.11.1989
(73) Titulaire: COMMISSARIAT A L'ENERGIE ATOMIQUE, 75015 Paris Cédex 15 (FR)
(72) Inventeur: Bechevet, Bernard, F-38640 Claix (FR); Calvat, Claude, F-38120 Saint Egrève (FR); Rolland, Bernard, F-38240 Meylan (FR); Valon, Bruno, F-38100 Grenoble (FR)
(74) Mandataire: Mongrédien, André

(56) Documents cités:
- FR-A- 2 239 163
- US-A- 4 481 406
- US-A- 4 599 069

## Description

La présente invention se rapporte à un dispositif de transmission de chaleur sous vide entre une source thermique chaude ou froide et un objet au moyen de grains intermédiaires disposés entre eux.

En microélectronique ou dans les supraconducteurs, on éprouve en effet souvent le besoin d'effectuer des dépôts ou des cristallisations sous vide à température élevée par exemple d'oxydes ou de métaux sur des substrats en couches minces. On peut réciproquement vouloir refroidir le substrat sur lequel les couches sont déposées afin d'entraver leur cristallisation. Dans les deux cas, le problème est le même : assurer la transmission thermique entre une source et le substrat.

Cette transmission peut se faire par rayonnement, mais ce procédé n'est généralement pas très efficace, d'autant plus que le substrat sur lequel les cristaux sont déposés peut être transparent aux rayonnements émis par la source thermique. La transmission peut aussi se faire par l'intermédiaire de supports solides entre la source et le substrat, qui peuvent comprendre le cadre sur lequel le substrat est fixé pour le maintenir au milieu de l'enceinte à vide. Ce procédé n'est pas tellement efficace non plus car les surfaces de contact entre le substrat et le cadre sont peu importantes, et de plus, on ne peut éviter l'apparition de gradients thermiques dans le substrat car la transmission de chaleur est plus facile près du cadre.

On a déjà pensé à délimiter entre le substrat et la source, à l'intérieur de l'enceinte à vide, une sous-enceinte étanche dans laquelle on introduit un gaz ou éventuellement un liquide à faible tension de vapeur.

Un inconvénient général de ce genre de techniques est qu'il faut assurer l'étanchéité vis-à-vis de l'enceinte à vide, ce qui n'est pas aisé quand on travaille à des températures élevées pour lesquelles les joints d'étanchéité ne sont pas prévus. Dans le cas de corps solides liquéfiés tels que le gallium ou l'indium, il faut accepter une certaine consommation de ces produits coûteux et des pollutions sont inévitables.

Ces inconvénients sont évités d'après l'invention en interposant entre le substrat et la source thermique une matière particulaire qui assure la transmission de chaleur uniformément,par des chemins multiples, tout en ne créant aucun problème d'étanchéité. Plus précisément, l'invention comprend un support dans l'enceinte à vide muni de moyens pour y monter l'objet, le support, l'objet et une paroi faisant partie de la source thermique, c'est-à-dire une paroi chauffée ou refroidie, délimitant une cavité remplie de grains conducteurs thermiques. La source thermique peut alors être de tout type approprié et notamment, dans le cas d'une source de chaleur, une résistance chauffante disposée de l'autre côté de la paroi ; cette résistance est installée dans une autre cavité qui peut être remplie de fluide isolant électrique et conducteur thermique.

Il est par ailleurs essentiel que les grains soient suffisamment fins pour assurer une bonne uniformité de la transmission de chaleur entre la source et le substrat, d'autant plus que les écarts thermiques peuvent provoquer des déformations de forme irrégulière auxquelles les grains intermédiaires doivent s'adapter. On peut donc préférer utiliser des billes sphériques de diamètre inférieur ou égal à 2 mm.

Par ailleurs, on peut adjoindre à l'enceinte à vide, solidaire de la cavité et communiquant avec elle, un réservoir dans lequel on maintient des grains quand aucun chauffage n'a lieu. On peut alors commodément monter ou démonter l'objet à chauffer sans voir s'écouler les grains à l'extérieur.

L'invention va à présent être décrite à l'aide des figures suivantes annexées à titre illustratif et nullement limitatif :
- la figure 1 est une vue d'ensemble en coupe du dispositif, et
- la figure 2 est une vue partielle prise selon la coupe II-II de la figure 1 et qui montre la conformation du support de l'objet à chauffer ou à refroidir et en particulier du réservoir à grains.

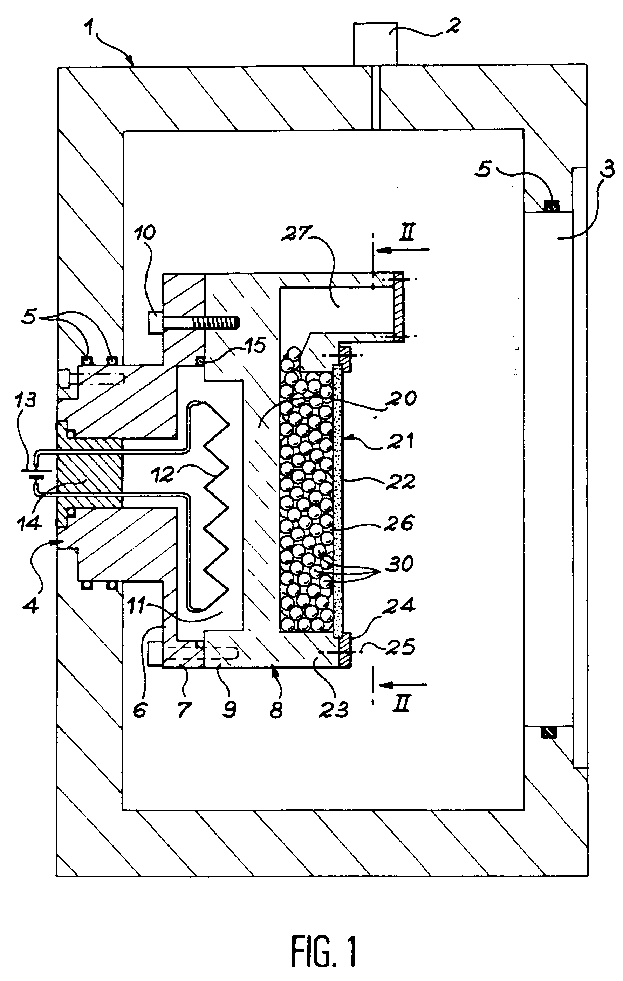

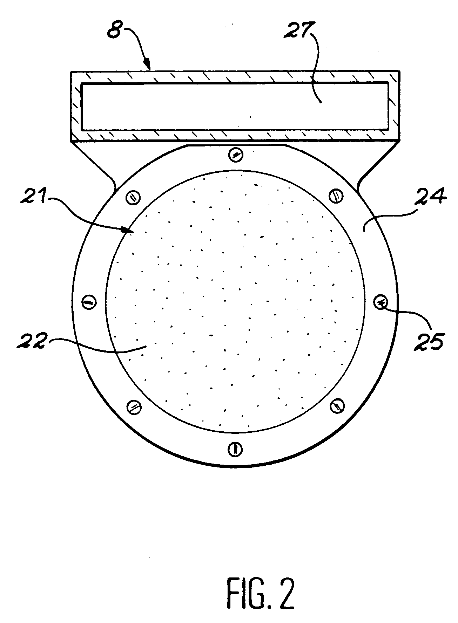

Sur les figures 1 et 2, l'enceinte à vide est référencée par 1. Le vide y est établi en cours de fonctionnement par une pompe à vide 2 disposée à l'extérieur de l'enceinte 1 et débouchant à l'intérieur de celle-ci. L'enceinte 1 est par ailleurs percée sur deux parois opposées par une porte 3 de dimensions relativement importantes et par un manchon 4. Des joints d'étanchéité 5 sont disposés aux découpes de l'enceinte 1.

Le manchon 4 s'élargit à l'intérieur de l'enceinte à vide 1 en une couronne 6 munie d'un épaulement périphérique 7. C'est ici qu'on fixe un support 8 de l'objet à chauffer ou à refroidir par un épaulement périphérique complémentaire 9. Les épaulements 7 et 9 sont fixés par des vis 10.

Le manchon 4 et le support 8 délimitent alors une cavité de source thermique 11 dans laquelle se trouve la source thermique 12, ici constituée par une résistance chauffante. D'autres solutions sont évidemment possibles et on pourrait par exemple envisager d'y établir une circulation forcée de fluide de chauffage ou de refroidissement. Avec la résistance 12, le vide peut régner dans la cavité de source thermique 11 ou, ce qui conduit à une meilleure conduction thermique, cette cavité 11 peut être remplie par un fluide isolant électrique tel que de l'air. Dans le premier cas, il est nécessaire d'établir une étanchéité par un bouchon qui ferme le manchon 4 entre la résistance 12 et une alimentation 13 de celle-ci ; le bouchon est référencé par 14. Dans le second cas, l'étanchéité est effectuée par rapport à l'enceinte à vide 1 en interposant un joint 15 entre les épaulements périphériques 7 et 9.

La paroi 20 du support 8 en contact avec la cavité de source thermique 11 constitue donc une sole chauffante ou de refroidissement. Il s'agit maintenant de transmettre cette énergie à l'objet à chauffer situé hors de la cavité de source thermique 11 ; cet objet est typiquement un substrat plan 21 monté sur le support 8, maintenu parallèlement à la paroi 20 et à quelque distance de celle-ci, et dont une face externe 22 opposée à la paroi 20 porte des couches minces sur la cristallisation desquelles on veut intervenir.

Le substrat 21 peut être concrètement constitué de verre, quartz, silicium ou grenat de gadolinium et gallium, et les couches minces d'hexaferrite de baryum, de nitrures, borures, oxydes, sans que ces listes soient limitatives. Le substrat 21 est maintenu en place entre une portée périphérique 23 qui s'élève à partir de la paroi 20 et une bague 24 serrée sur l'extrémité de la portée périphérique 23 par des vis 25. La paroi 20, le substrat 21 et la portée périphérique 23 délimitent une cavité 26 qu'il est difficile de rendre étanche pour la remplir de gaz afin d'améliorer la transmision de chaleur. Le substrat 21 n'est en effet en contact avec la portée 23 et la bague 24 que sur une faible largeur de sa périphérie et il est donc difficile d'installer des joints d'étanchéité à cet endroit. Dans l'invention, le vide règne donc dans la cavité 26.

La cavité 26 est généralement close, sauf à une extrémité où elle peut avantageusement déboucher sur un réservoir 27. Au cours du traitement, la cavité 26 est remplie d'une matière granulaire conductrice thermique qui peut être constituée avantageusement de billes 30 d'environ 1 mm de diamètre. Le réservoir 27 est alors au-dessus de la cavité 26, ce qui fait que les billes 30 tendent à emplir cette dernière avec une pression sur ses parois déterminée par le poids des billes 30. Si le substrat 21 se déforme par suite de son échauffement, l'écoulement des billes 30 qui s'ensuit permet de s'adapter à cette modification de forme.

De plus, la transmission de chaleur à partir de la paroi 20 s'effectue par des chemins thermiques sinueux multiples définis par les points de contact entre les billes 30 et se fait uniformément sur toute la surface du substrat 21, même s'il existe un gradient thermique sur la paroi 20, ce qui permet des échauffements à la fois plus réguliers et plus importants que si la chaleur avait dû passer par la portée périphérique 23.

Ces divers avantages expliquent également la supériorité des grains tels que les billes 30 sur d'autres solides intermédiaires que l'on aurait pu adopter, par exemple des rouleaux, plots ou blocs qui n'auraient pas suivi les dilatations thermiques du substrat 21, auraient été plus délicats à installer avec des tolérances correctes et auraient produit des transferts thermiques moins uniformes.

Les billes 30 peuvent être avantageusement contituées du même matériau que le substrat 21 afin d'éviter les pollutions par contact.

On a constaté dans un exemple précis que, la paroi 20 étant à une température de 560°C, la température du substrat 21 était élevée de 130°C quand les billes 30 étaient introduites dans la cavité 26.

Quand le traitement est terminé, on rétablit la pression atmosphérique dans l'enceinte 1 et on enlève la porte 3 ; les vis 10 sont alors retirées et on peut ôter le support 8. Le substrat 21 est ensuite retiré à l'extérieur par démontage de la bague 24. Dans l'intervalle, le support 8 a été retourné de façon à placer le réservoir 27 sous la cavité 26, si bien que les billes 30 ont reflué dans le réservoir 27 et qu'il n'est pas nécessaire de se préoccuper davantage de celles-ci avant de retirer le substrat 21.

Le montage d'un nouveau substrat 21 dans l'enceinte à vide 1 se fait par des opérations inverses.

## Revendications

1. Dispositif de transmission de chaleur entre une source thermique (12) et un objet (21) dans une enceinte à vide (1), comprenant un support (8, 4) dans l'enceinte muni de moyens (24, 25) pour y monter l'objet (21), dispositif dans lequel le support (8), l'objet et une paroi (20) faisant partie de la source thermique (12) délimitent une cavité (26), caractérisé en ce que la cavité (26) est remplie de grains (30) conducteurs thermiques.

2. Dispositif de transmission de chaleur selon la revendication 1, caractérisé en ce que la cavité (26) se raccorde à un réservoir (27) où les grains (30) sont refoulés quand l'objet (21) est démonté du support (8).

3. Dispositif de transmission de chaleur selon l'une quelconque des revendications 1 ou 2, caractérisé en ce que les grains (30) sont des billes de diamètre inférieur ou égal à 2 mm.

4. Dispositif de transmission de chaleur selon l'une quelconque des revendications 1 à 3, caractérisé en ce que la source thermique (12) comprend une résistance chauffante.

5. Dispositif de transmission de chaleur selon la revendication 4, caractérisé en ce que la résistance chauffante (12) est installée dans une autre cavité (11), creusée dans le support (8, 4) et remplie de fluide.

6. Dispositif de transmission de chaleur selon l'une quelconque des revendications précédentes, caractérisé en ce que les grains (30) et l'objet (21) sont constitués du même matériau.

## Patentansprüche

1. Vorrichtung zur Wärmeübertragung zwischen einer thermischen Quelle (12) und einem Objekt (21) in einer Vakuumkammer (1), welche eine Halterung (8, 4) in einer Kammer umfasst, welche mit Mitteln (24, 25) ausgestattet ist, um dort ein Objekt (21) zu montieren, eine Vorrichtung, in welcher die Halterung (8), das Objekt und eine Wandung (20) zur thermischen Quelle (12) gehören, welche einen Hohlraum (26) eingrenzt,
dadurch **gekennzeichnet**,
daß der Hohlraum (26) mit thermisch leitenden Körnern (30) gefüllt ist.

2. Verfahren zur Wärmeübertragung nach Anspruch 1, dadurch gekennzeichnet, daß der Hohlraum (26) sich an einen Behälter (27) anpaßt, wohin die Körner (30) zurückgestaut werden, wenn das Objekt (21) aus der Halterung (8) genommen wird.

3. Vorrichtung zur Wärmeübertragung gemäß einem der Ansprüche 1 oder 2, dadurch gekennzeichnet, daß die Körner (30) Kügelchen mit einem Durchmesser kleiner oder gleich 2 mm sind.

4. Vorrichtung zur Wärmeübertragung gemäß einem der Ansprüche 1 bis 3, dadurch gekennzeichnmet, daß die thermishe Quelle (12) einen heizenden Widerstand umfaßt.

5. Vorrichtung zur Wärmeübertragung gemäß Anspruch 4, dadurch gekennzeichnet, daß der heizende Widerstand (12) in einem anderen, in die Halterung (8, 4) vertieften und mit Flüssigkeit aufgefüllten Hohlkörper (11) installiert ist.

6. Vorrichtung zur Wärmeübertragung gemäß einem der vorhergehenden Ansprüche, dadurch gekennzeichnet, daß die Körner (30) und das Objekt (21) aus demselben Material gebildet sind.

## Claims

1. Apparatus for the transmission of heat between a thermal source (12) and an object (21) in a vacuum enclosure (1), comprising a support (8,4) in the enclosure provided with means (24, 25) for installing the object (21) there, apparatus wherein the support (8), object and wall (20) form part of the thermal source (12) and define a cavity (26), characterized in that the cavity is filled with heat conducting grains (30).

2. Heat transmission apparatus according to claim 1, characterized in that the cavity (26) is connected to a reservoir (27), where the grains (30) are forced back when object (21) is dismantled from support (8).

3. Heat transmission apparatus according to either of the claims 1 or 2, characterized in that the grains (30) are balls with a diameter equal to or below 2 mm.

4. Heat transmission apparatus according to any one of the claims 1 to 3, characterized in that the thermal source (12) comprises a heating resistor.

5. Heat transmission apparatus according to claim 4, characterized in that the heating resistor (12) is installed in another cavity (11) made in support (8,4) and filled with fluid.

6. Heat transmission apparatus according to any one of the preceding claims, characterized in that the grains (30) and object (21) are made from the same material.
